# EUROPEAN PATENT SPECIFICATION

(11) **EP 3 513 639 B1**
(45) Date of publication and mention of the grant of the patent: **22.04.2020**
(21) Application number: 16770230.7
(22) Date of filing: 14.09.2016
(51) Int. Cl.: H05K 7/20

(54) **COOLING ARRANGEMENT**
KÜHLANORDNUNG
AGENCEMENT DE REFROIDISSEMENT

(43) Date of publication of application: 24.07.2019
(73) Proprietor: ABB Power Grids Switzerland AG, 5400 Baden (CH)
(72) Inventor: BEL FDHILA, Rebei, 724 76 Västerås (SE); RUSSBERG, Gunnar, 724 62 Västerås (SE); PERSSON, Erik, 723 35 Västerås (SE); ERIKSSON, Thomas, R., 743 86 Bälinge (SE)
(74) Representative: Kransell & Wennborg KB
(86) International application number: PCT/EP2016/071648
(87) International publication number: WO 2018/050217

(56) References cited:
- WO-A1-01/31987
- WO-A1-2016/008509
- WO-A1-2016/070913
- JP-A- S6 088 451
- US-A1- 2013 063 897
- US-A1- 2016 128 231

## Description

### FIELD OF THE INVENTION

The present invention generally relates to the field of cooling of electrical components. More specifically, the present invention relates to a cooling arrangement for high-voltage applications.

### BACKGROUND OF THE INVENTION

Relatively high temperatures may be generated in arrangements or devices comprising one or more electrical components. This may especially be the case if many electrical components are driven at the same time. The effect of heat may in some cases be detrimental to the electrical components, and their operation may be negatively affected. Hence, thermal management (e.g. cooling) is often important to prevent thermal damage of electrical arrangements and devices.

In the case of high voltage direct current (HVDC) converters, wherein these converters are adapted to convert high voltage direct current (DC) to alternating current (AC) or the reverse, large amounts of heat are often generated during operation. The heat primarily originates from power electronic valves, switching current at high frequency, and to some degree also from conducting parts like bus bars. Conventionally, power semiconductor switch elements are cooled by forced water flow, while capacitors are cooled by free convection of air, with capacitor containers being exposed via all surfaces to the surrounding circulating air. With the capacitor heating intensity per volume being limited, and despite a rather low thermal conductivity of the container filler material, air cooling on all capacitor container surfaces ensures minimal length of the thermal paths and proves sufficient for preventing undesirable hot spot temperature levels in the capacitor that would significantly affect the life-cycle of the capacitor. However, with increasing footprint requirements, the heat-generating components are packed more closely, the total heating power density increases, and alternative cooling concepts may have to be envisaged. Furthermore, solutions applying convective or forced gas cooling are not possible for gas-insulated high-power applications, as these solutions often demand voluminous flows and/or bulky connections. The conventional water cooling does have sufficient cooling capacity, but there are serious issues with material compatibility: no leakage or diffusion of water can be tolerated in an insulating gas environment, since aggressive chemical compounds may else be formed in addition to a degradation of the dielectric properties of the gas. Hence, alternative solutions for cooling are of interest which avoid water leakage in an insulating gas environment, and which furthermore provide a compact cooling arrangement and/or efficient cooling.

The US published patent application US 2013/063897 A1 discloses a modular, high-power drive stack cooled with vaporizable dielectric fluid. The stack system comprises a vaporizable dielectric fluid system and a plurality of receivers for accepting a plurality of modules containing power electronics.

The US published patent application US 2016/128231 A1 describes a system and method for cooling electrical components of a power converter.

### SUMMARY OF THE INVENTION

It is an object of the present invention to mitigate the above problems and to provide a cooling system, as well as a method, which avoids water leakage and which furthermore is compact and/or provides an efficient cooling.

This and other objects are achieved by providing a cooling system and a method having the features in the independent claims. Preferred embodiments are defined in the dependent claims.

Hence, according to a first aspect of the present invention, there is provided a cooling system according to the features of claim 1.

According to a second aspect of the present invention, there is provided a method for cooling at least one electrical element for electrical conversion according to the features of claim 13.

Thus, the present invention is based on the idea of providing a cooling system for gas-insulated applications wherein the same medium is used for electrical insulation and cooling of one or more electrical elements. Hence, low temperature insulation gas in its liquid state is used as coolant, i.e. a refrigerating medium. The liquid medium is formed by a condenser (i.e. a liquefier) and/or a compressor for converting gaseous medium to liquid medium. The liquid medium is then transported to the heat-exchanging element(s) where it evaporates and depressurizes, absorbing thermal power corresponding to the rate of change in its temperature and latent heat. The electrical element(s), which are in thermal contact with the heat-exchanging element(s) is (are) hereby cooled by the medium in the heat-exchanging element(s). In other words, the medium provides a refrigeration effect, whereby the electrical elements are cooled, and the heat-exchanging elements discharge the medium as vapor. Furthermore, the circulation means provides a cooling cycle by circulating the medium between the heat-exchanging element(s) and the condenser(s).

The present invention relates to a cooling system for at least one electrical element for electrical conversion. The cooling system comprises an electrically insulating medium for insulation of the at least one electrical element. By the term "electrically insulating medium", it is here meant a dielectric or insulating medium. Dielectric gases are used as electrical insulators in high voltage applications, e.g. transformers, gas insulated substations (GIS), SF6 circuit breakers, high voltage switchgear, HVDC converters, etc. The cooling system further comprises at least one condenser configured to condense said medium from a gaseous state to a liquid state. In other words, the condenser has one or more inlets for the medium in a gaseous state and one or more outlets for the medium in a liquid state. The cooling system further comprises at least one heat-exchanging element fluidly connected to the at least one condenser. By the term "heat-exchanging element", it is here meant a heat sink, a heat exchanger, or the like. Furthermore, by "fluidly connected", it is here meant that there is a connection (e.g. piping) between the heat-exchanging element(s) and the condenser(s) such that medium in its fluid or liquid state may pass from the condenser(s) to the heat-exchanging element(s). The at least one heat-exchanging element is configured for thermal contact with the at least one electrical element for cooling the at least one electrical element by said medium. By "thermal contact", it is here meant that heat and/or cold may be transported between the heat-exchanging element and the electrical element. Furthermore, the at least one heat-exchanging element is configured to evaporate the medium from a liquid state during cooling of the at least one electrical element. By "evaporate", it is here meant that the heat-exchanging element is able to provide a transition of the medium from a fluid to a gaseous state. The at least one heat-exchanging element is further configured to discharge the evaporated medium. By "discharge", it is here meant that the heat-exchanging element is configured to release or give off the evaporated medium. The cooling system further comprises at least one circulation means configured to circulate the medium from the at least one condenser to the at least one heat-exchanging element, and to circulate the medium discharged from the at least one heat-exchanging element back to the at least one condenser. Hence, there is provided a circuit for the medium between the condenser(s) and the heat-exchanging element(s).

The present invention is advantageous in that the use of a liquefied insulation gas as a coolant, i.e. that the same medium is used for insulation as well as cooling properties, overcomes problems related to material compatibility. As a water leakage or diffusion of water may be hazardous in an environment of an electrically insulating medium, any occurring leakages of a liquefied insulation gas as a coolant may have a negligible effect. It will be appreciated that the (over)pressure of the electrically insulating medium is moderate during the cooling operation, and the cooling arrangement may hereby withstand a pressure increase as a result of even a relatively large leak or puncture. The consequences of such a failure may be spatially restricted (e.g. restricted to an enclosure enclosing one or more electrical elements), such that a risk of contamination of the electrical element(s) is minimized.

The present invention is further advantageous in that only one medium needs to be used in the arrangement, as the medium may serve both as a coolant and as an insulating medium.

The present invention is further advantageous in that the arrangement may be relatively compact. It will be appreciated that by using a phase transition of the medium from gas to liquid, the liquid medium may carry cooling power in a relatively compact manner, comparable to water cooling.

The present invention is further advantageous in that the use of a medium with a relatively low temperature makes it possible to significantly cool electrical elements and or components provided in the electrical elements (e.g. bus bar conductors). The efficient cooling thus obtained reduces the resistivity of the components and saves weight/volume.

According to an embodiment of the present invention, the at least one heat-exchanging element is fluidly connected in parallel to the at least one condenser. In other words, each heat-exchanging element has a separate fluid connection with the condenser(s). The present embodiment is advantageous in that the cooling of the electrical elements may be performed more effectively compared to an arrangement comprising serial connections.

According to an embodiment of the present invention, the at least one heat-exchanging element comprises a plurality of ducts for guiding the medium. The present embodiment is advantageous in that the cooling of the at least one electrical element (i.e. the heat exchange between the heat-exchanging element(s) and the electrical element(s)) becomes more efficient.

According to an embodiment of the present invention, there is provided a cooling unit thermally coupled to the at least one condenser, wherein the cooling unit is configured to lower the temperature of the medium in the condenser beyond the gas-liquid phase transition point of the medium, such that the medium condenses from a gaseous state to a liquid state. Hence, the cooling unit may cool the medium from its gas phase to its liquid phase. The present embodiment is advantageous in that the cooling unit (which may use water as a coolant) may efficiently and conveniently cool the medium such that it passes its gas-liquid phase transition point.

According to an embodiment of the present invention, the cooling system may further comprise a compressor configured to increase the pressure of the medium in its gaseous state beyond the gas-liquid phase transition point of the medium, such that the medium condenses from a gaseous state to a liquid state. Hence, the compressor may compress the medium such that the medium undergoes a transition from a gaseous state to a liquid state. The present embodiment is advantageous in that the compressor provides a convenient manner of increasing the pressure such that the medium undergoes a phase transition.

According to an embodiment of the present invention, the compressor is configured to increase the pressure of the medium to 0.4 - 3 MPa. It will be appreciated that an insulation system comprising SF6 at 4 - 5 bar (0.4 - 0.5 MPa) will need just a few bar additional overpressure to work at -15° to -20°, i.e., ordinary household freezer temperatures.

According to an embodiment of the present invention, there is provided at least one conduit arranged as a circuit between the at least one condenser and the at least one heat-exchanging element. In other words, the conduit(s) of the cooling system is a separate, closed circuit between the heat-exchanging element(s) and the condenser in which the electrically insulating medium acts as a cooling medium.

According to an embodiment of the present invention wherein, the medium is at least one of sulfur hexafluoride (SF₆) and 1,1,1,2-Tetrafluoroethane. It will be appreciated that SF6 is an inorganic, colorless, odorless, non-flammable gas, which is an excellent electrical insulator.

According to an embodiment of the present invention, the cooling system comprises at least one converter cell for electrical conversion, and the converter cell(s) comprise(s) at least one capacitor shield, at least one capacitor element and at least one switching device. Hence, in the previously described embodiments, the at least one electrical element may be at least one converter cell for electrical conversion.

According to an embodiment of the present invention, the at least one converter cell is arranged coaxially to form a stack of converter cells. Hence, the stack of converter cells may be arranged coaxially, leading to a relatively compact converter system.

According to an embodiment of the present invention, the at least one converter cell and the at least one heat-exchanging element are arranged alternately into a stack. In other words, a heat-exchanging element may be placed on top (or beside) a converter cell, on top of which (or beside) yet another heat-exchanging element is placed, and so on. The present embodiment is advantageous in that the thermal contact between the heat exchanger(s) and the converter cell(s) may be even further improved, leading to an even more efficient cooling.

According to an embodiment of the present invention, the system further comprises at least one first conduit arranged between the at least one condenser and the at least one heat-exchanging element for a transportation of the medium in a liquid state. Furthermore, at least one second conduit is arranged between the enclosure and the at least one condenser for a transportation of the medium in a gaseous state. Hence, the embodiment provides a cooling circuit for one or more electrical elements inside a moderately pressurized enclosure containing insulation gas. The electrical element(s), which generate heat losses, are equipped with heat exchangers (sinks) that are fed with cold, liquefied insulation gas. The condenser in turn is fed by gas in its normal temperature and pressure state, collected from the existing gas insulation system. Hence, the medium, which both acts as a coolant and as an insulating medium, is recollected for continued cooling cycles in the converter cooling system.

According to an embodiment of the present invention, the at least one element of the method is at least one converter cell for electrical conversion, wherein the at least one converter cell comprises at least one capacitor shield, at least one capacitor element and at least one switching device.

It will be appreciated that the described advantages of the cooling system according to the first aspect of the present invention also hold for the method according to the second aspect of the present invention.

Further objectives of, features of, and advantages with, the present invention will become apparent when studying the following detailed disclosure, the drawings and the appended claims.

### BRIEF DESCRIPTION OF THE DRAWINGS

This and other aspects of the present invention will now be described in more detail, with reference to the appended drawings showing embodiment(s) of the invention.
Fig. 1 is a schematic drawing of a cooling arrangement 100 according to an exemplifying embodiment of the present invention.
Fig. 2 shows a schematic drawing of a converter cell 500 according to an exemplifying embodiment of the present invention.

### DETAILED DESCRIPTION

Exemplifying embodiments will now be described more fully hereinafter with reference to the accompanying drawings, in which currently preferred embodiments are shown. The invention may, however, be embodied in many different forms and should not be construed as limited to the embodiments set forth herein; rather, these embodiments are provided for thoroughness and completeness, and fully convey the scope of the invention to the skilled person.

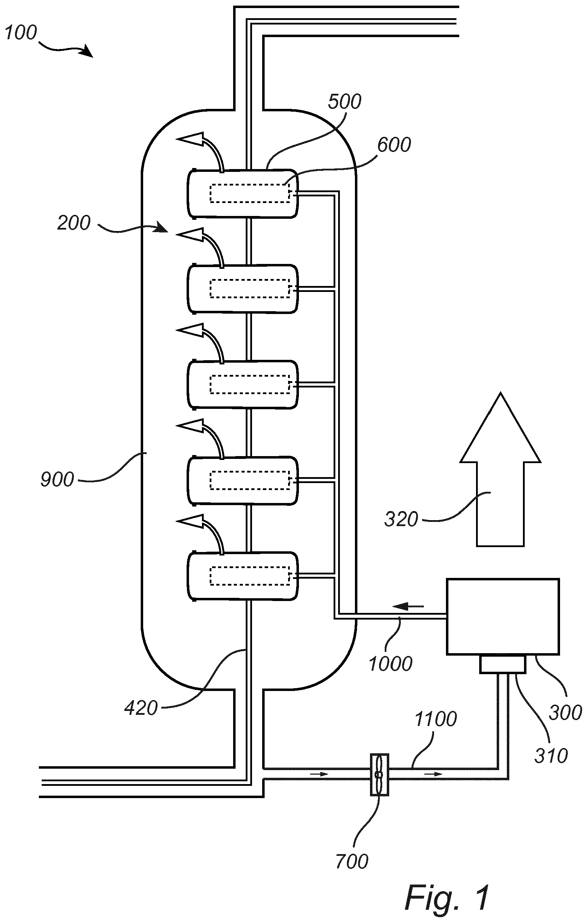

Fig. 1 schematically shows a cooling arrangement 100 for at least one electrical element for electrical conversion, according to an exemplifying embodiment of the present invention. The cooling arrangement 100 comprises an electrically insulating medium 200, i.e. a dielectric or insulating medium, which is used both as a coolant and an insulating medium. For example, the medium 200 may be sulfur hexafluoride (SF₆), 1,1,1,2-Tetrafluoroethane (R134a), or the like. It will be appreciated that the present disclosure is not limited to these examples and that other gases, in particular SF6-free gases, with similar insulation properties may be used. Furthermore, any combination of SF6, R134a, SF6-free gas, or the like, may be used.

The cooling arrangement 100 further comprises a condenser 300 (liquefier) which is configured to condense the medium 200 lead to the condenser 300. The condenser 300 converts the medium 200 from a gaseous state to a liquid state. It should be noted that there may be several condensers 300 present, instead of just one as shown in Fig. 1. During operation, the condenser 300 produces heat 320 as the phase transition from gas to liquid of the medium 200 is an exothermal reaction. For example, the condenser 300 may be thermally coupled to a cooling unit (not shown) which is configured to lower the temperature of the medium 200 in the condenser 300 beyond the gas-liquid phase transition point of the medium 200, such that the medium 200 condenses from a gaseous state to a liquid state.

Alternatively, or in combination with a lowering of the temperature of the medium 200, the cooling arrangement 100 may comprise a compressor 310. In Fig. 1, the position of the compressor 310 is before the condenser 300 (in a downstream direction of the medium 200), but the position of the compressor 310 may be positioned elsewhere. For example, the condenser 300 itself may comprise the compressor 310. The compressor 310 is configured to increase the pressure of the medium 200 in its gaseous state beyond the gas-liquid phase transition point of the medium 200, such that the medium 200 condenses from a gaseous state to a liquid state.

After the medium 200 has condensed, it is lead away from the condenser(s) 300 (e.g. via a conduit system) to one or more electrical elements 500. In Fig. 1, five electrical elements 500 are arranged to form a stack of electrical elements 500. By "stack", it is meant a column of electrical elements 500, i.e. a plurality of electrical elements 500 stapled on top of each other. Although five electrical elements 500 are schematically indicated in Fig. 1, it should be noted that the cooling arrangement 100 may comprise an arbitrary number of these electrical elements 500. It will be appreciated that the electrical elements 500 may be converter cell(s) 500 configured to provide electrical conversion, i.e. conversion from AC to DC or vice versa. The converter cell 500 may comprise a capacitor shield, a capacitor element and at least one switching device. In case of the electric elements 500 being converter cells, the latter may be connected by an electric line 420, which is merely indicated in a schematic manner.

Each electrical element 500 may further comprise at least one heat-exchanging element 600, schematically indicated in Fig. 1 by dashed lines. Each heat-exchanging element 600 is fluidly connected (i.e. fluidly coupled, e.g. via a conduit system) to the condenser 300. Furthermore, the heat-exchanging elements 600 are in thermal contact with the electrical elements 500 such that the electrical elements 500 are cooled by the medium 200 flowing through the heat-exchanging elements 600. During this cooling of the electrical elements 500, the heat-exchanging elements 600 are configured to evaporate the medium 200. Hence, in the present heat-exchanging process, heat is transferred from the electrical elements 500 to the medium 200 in the heat-exchanging elements 600 such that the medium 200 undergoes a transition from its fluid state to its gaseous state. The medium 200 evaporated in this manner may thereafter be discharged (i.e. released) by the heat-exchanging elements 600 into a space outside the heat-exchanging elements 600.

The cooling arrangement 100 further comprises at least one circulation means 700, such as a fan, a pump, or the like. The circulation means 700 may circulate the medium 200 from the condenser 300 into the heat-exchanging elements 600 inside the electrical elements 500, and thereafter from outside the electrical elements 500 back to the condenser 300. Hence, the circulation means 700 achieves a closed circuit of medium 200 in the cooling arrangement 100.

As an alternative to the cooling arrangement 100 as shown in Fig. 1, it will be appreciated that the cooling arrangement 100 may instead comprise at least one conduit arranged as a circuit (not shown) between the at least one condenser and the at least one heat-exchanging element. In other words, the conduit(s) of the cooling system may be a separate, closed circuit between the heat-exchanging element(s) and the condenser in which the electrically insulating medium acts as a cooling medium.

According to an embodiment of the present invention, there is provided a cooling system which comprises a cooling arrangement 100 as previously described. The converter cooling system further comprises an enclosure 900, enclosing the electrical elements 500, as indicated in Fig. 1. The electrical elements 500 are configured to discharge medium 200 evaporated by the heat-exchanging element(s) 600 into the enclosure 900. Here, the evaporated medium 200 (i.e. vapor) mixes with the surrounding insulation gas in the enclosure 900. A first conduit 1000 is arranged between the condenser 300 and the electrical elements 500 for a transportation of the medium 200 in a liquid state, and a second conduit 1100 is arranged between the enclosure 900 and the condenser 300 for a transportation of the medium 200 in a gaseous state. Hence, the medium 200 is recollected for continued cooling cycles in the cooling system.

The electrical elements 500 within the enclosure 900 are connected in series to form an electrical equipment or system (e.g. a converter). Furthermore, the electrical elements 500 and the heat-exchanging elements 600 are arranged alternately into a stack, to ensure a thermal contact between the electrical elements 500 and the heat-exchanging elements 600.

The enclosure 900 may extend mainly along an axial direction, and the electrical elements 500 and the heat-exchanging elements 600 may hereby form a stack which extends along this axial direction.

In Fig.1, the enclosure 900 has a cylindrical shape. Furthermore, the disc-shaped electrical elements 500 form a column of electrical elements 500 having a cylindrical shape, which provides a relatively homogeneous electric field in case the electrical elements 500 are converter cells. In some embodiments, at least one of the electrical elements 500 and/or at least one of the heat-exchanging elements 600 may be detachably arranged.

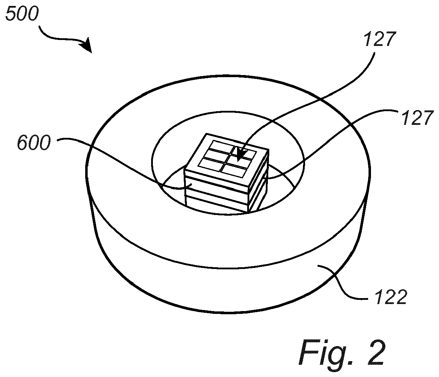

Figure 2 shows an electrical element 500 in form of a converter cell including a (high voltage) capacitor shield 122 and a switching device such as a semiconductor component 127. The capacitor shield 122 surrounds the switching device. Without loss of generality and for illustrating purposes only, the semiconductor component 127 may be an arrangement of one or more thyristors or insulated-gate bipolar transistors (IGBTs), depending on the desired electrical equipment (e.g. type of converter). At least one capacitor element (not shown) is arranged or enclosed within the capacitor shield 122 (i.e. within the volume defined by the interior of the body of the capacitor shield). In the embodiment shown in Figure 2, the capacitor shield 122 surrounds the semiconductor component(s) 127 and is disc-shaped. Hence, the capacitor shield 122 is annular and defines a center hole in which the semiconductor component 127 may be placed.

A heat-exchanging element 600 is arranged under the (top) semiconductor component 127 for cooling purposes. Furthermore, another semiconductor component 127 is arranged under the heat-exchanging element 600. Hence, the switching devices (i.e. semiconductor components 127) and the heat-exchanging elements 600 are arranged alternately into a stack. It will be appreciated that the number of semiconductor components 127 and heat-exchanging elements 600 may be arbitrary. Furthermore, the converter cell 500 shown in Figure 2 is particularly suitable for forming a cylinder-like stack of converter cells 500 to be arranged within a cylinder-like enclosure 900, as schematically shown in Fig. 1.

The person skilled in the art realizes that the present invention by no means is limited to the preferred embodiments described above. On the contrary, many modifications and variations are possible within the scope of the appended claims. For example, it will be appreciated that the figures are merely schematic views of cooling arrangements according to embodiments of the present invention. Hence, any elements/components of the cooling arrangement 100 such as the condenser(s) 300, electrical elements 500, enclosure 900, etc, may have different dimensions, shapes and/or sizes than those depicted and/or described.

In the claims, the word "comprising" does not exclude other elements or steps, and the indefinite article "a" or "an" does not exclude a plurality.

## Claims

1. A cooling system, comprising
at least one electrical element,
an electrically insulating medium (200) for insulation of the at least one electrical element,
at least one condenser (300) configured to condense said medium from a gaseous state to a liquid state, and
at least one heat-exchanging element (600) fluidly connected to said at least one condenser and configured for thermal contact with the at least one electrical element for cooling the at least one electrical element by said medium, wherein said at least one heat-exchanging element is configured to evaporate said medium from a liquid state during cooling of the at least one electrical element and to discharge the evaporated medium, **characterized in that** the cooling system further comprises
an enclosure (900) enclosing said at least one electrical element, wherein said at least one heat-exchanging element is configured to discharge evaporated medium into said enclosure, and
at least one circulation means (700) configured to circulate said medium from said at least one condenser to said at least one heat-exchanging element, and to circulate said medium discharged from said at least one heat-exchanging element back to said at least one condenser.

2. The cooling system according to claim 1, wherein said at least one heat-exchanging element is fluidly connected in parallel to said at least one condenser.

3. The cooling system according to claim 1 or 2, wherein said at least one heat-exchanging element comprises a plurality of ducts for guiding said medium.

4. The cooling system according to any one of the preceding claims, further comprising a cooling unit thermally coupled to said at least one condenser, wherein said cooling unit is configured to lower the temperature of said medium in the condenser beyond the gas-liquid phase transition point of said medium, such that said medium condenses from a gaseous state to a liquid state.

5. The cooling system according to any one of the preceding claims, further comprising a compressor (310) configured to increase the pressure of said medium in its gaseous state beyond the gas-liquid phase transition point of said medium, such that said medium condenses from a gaseous state to a liquid state.

6. The cooling system according to claim 5, wherein said compressor is configured to increase the pressure of said medium to 0.4 - 3 MPa.

7. The cooling system according to any one of the preceding claims, wherein at least one conduit is arranged as a circuit between said at least one condenser and said at least one heat-exchanging element.

8. The cooling system according to any one of the preceding claims, wherein said medium is at least one of sulfur hexafluoride (SF₆) and 1,1,1,2-Tetrafluoroethane.

9. The cooling system according to any one of the preceding claims, further comprising
at least one converter cell (500) for electrical conversion, wherein said at least one converter cell comprises at least one capacitor shield (122), at least one capacitor element and at least one switching device (127).

10. The cooling system according to claim 9, wherein said at least one converter cell is arranged coaxially to form a stack of converter cells.

11. The cooling system according to claim 9 or 10, wherein said at least one switching device and said at least one heat-exchanging element are arranged alternately into a stack.

12. The cooling system according to any one of the preceding claims,
wherein at least one first conduit (1000) is arranged between said at least one condenser and said at least one heat-exchanging element for a transportation of said medium in a liquid state, and at least one second conduit (1100) is arranged between said enclosure and said at least one condenser for a transportation of said medium in a gaseous state.

13. A method for cooling at least one electrical element, comprising the steps of
providing an electrically insulating medium for insulation of the at least one electrical element;
condensing the medium from a gaseous state to a liquid state by means of a condenser;
transporting the medium in the liquid state to at least one heat-exchanging element fluidly connected to the condenser and configured for thermal contact with the at least one electrical element for cooling the at least one electrical element by the medium,
**characterized by**
providing an enclosure enclosing said at least one electrical element and evaporating the medium into said enclosure from a liquid state during cooling of the at least one electrical element by the at least one heat-exchanging element, and
circulating the medium from the condenser to the at least one heat-exchanging element and circulating the medium evaporated from the at least one heat-exchanging element back to the condenser.

14. The method according to claim 13, wherein the at least one electrical element is at least one converter cell for electrical conversion, wherein said at least one converter cell comprises at least one capacitor shield, at least one capacitor element and at least one switching device.

## Patentansprüche

1. Kühlsystem, das Folgendes umfasst:
mindestens ein elektrisches Element,
ein elektrisch isolierendes Medium (200) zur Isolierung des mindestens einen elektrischen Elements,
mindestens einen Verflüssiger (300), der dazu ausgelegt ist, das Medium aus einem gasförmigen Zustand in einen flüssigen Zustand zu kondensieren, und
mindestens ein Wärmetauschelement (600), das mit dem mindestens einen Verflüssiger fluidverbunden und zum thermischen Kontakt mit dem mindestens einen elektrischen Element zum Kühlen des mindestens einen elektrischen Elements durch das Medium ausgelegt ist, wobei das mindestens eine Wärmetauschelement dazu ausgelegt ist, das Medium während des Kühlens des mindestens einen elektrischen Elements aus einem flüssigen Zustand zu verdampfen und das verdampfte Medium auszulassen, **dadurch gekennzeichnet, dass** das Kühlsystem ferner Folgendes umfasst:
eine Einhausung (900), die das mindestens eine elektrische Element umschließt, wobei das mindestens eine Wärmetauschelement dazu ausgelegt ist, verdampftes Medium in die Einhausung auszulassen, und
mindestens ein Zirkulationsmittel (700), das dazu ausgelegt ist, das Medium von dem mindestens einen Verflüssiger zu dem mindestens einen Wärmetauschelement zu zirkulieren, und das aus dem mindestens einen Wärmetauschelement ausgelassene Medium zurück zu dem mindestens einen Verflüssiger zu zirkulieren.

2. Kühlsystem nach Anspruch 1, wobei das mindestens eine Wärmetauschelement parallel mit dem mindestens einen Verflüssiger fluidverbunden ist.

3. Kühlsystem nach Anspruch 1 oder 2, wobei das mindestens eine Wärmetauschelement mehrere Kanäle zum Leiten des Mediums umfasst.

4. Kühlsystem nach einem der vorhergehenden Ansprüche, das ferner eine mit dem mindestens einen Verflüssiger thermisch gekoppelte Kühleinheit umfasst, wobei die Kühleinheit dazu ausgelegt ist, die Temperatur des Mediums in dem Verflüssiger über den Gas-Flüssigkeit-Phasenübergangspunkt des Mediums hinaus zu senken, sodass das Medium aus einem gasförmigen Zustand in einen flüssigen Zustand kondensiert.

5. Kühlsystem nach einem der vorhergehenden Ansprüche, das ferner einen Kompressor (310) umfasst, der dazu ausgelegt ist, den Druck des Mediums in seinem gasförmigen Zustand über den Gas-Flüssigkeit-Phasenübergangspunkt des Mediums hinaus zu erhöhen, sodass das Medium aus einem gasförmigen Zustand in einen flüssigen Zustand kondensiert.

6. Kühlsystem nach Anspruch 5, wobei der Kompressor dazu ausgelegt ist, den Druck des Mediums auf 0,4 bis 3 MPa zu erhöhen.

7. Kühlsystem nach einem der vorhergehenden Ansprüche, wobei mindestens eine Leitung als ein Kreis zwischen dem mindestens einen Verflüssiger und dem mindestens einen Wärmetauschelement eingerichtet ist.

8. Kühlsystem nach einem der vorhergehenden Ansprüche, wobei es sich bei dem Medium um Schwefelhexafluorid (SF₆) und/oder 1,1,1,2-Tetrafluorethan handelt.

9. Kühlsystem nach einem der vorhergehenden Ansprüche, das ferner Folgendes umfasst:
mindestens eine Wandlerzelle (500) zur elektrischen Umwandlung, wobei die mindestens eine Wandlerzelle mindestens eine Kondensatorabschirmung (122), mindestens ein Kondensatorelement und mindestens eine Schaltvorrichtung (127) umfasst.

10. Kühlsystem nach Anspruch 9, wobei die mindestens eine Wandlerzelle koaxial angeordnet ist, um einen Wandlerzellenstapel zu bilden.

11. Kühlsystem nach Anspruch 9 oder 10, wobei die mindestens eine Schaltvorrichtung und das mindestens eine Wärmetauschelement alternierend in einen Stapel angeordnet sind.

12. Kühlsystem nach einem der vorhergehenden Ansprüche, wobei mindestens eine erste Leitung (1000) zum Transport des Mediums in einem flüssigen Zustand zwischen dem mindestens einen Verflüssiger und dem mindestens einen Wärmetauschelement angeordnet ist, und mindestens eine zweite Leitung (1100) zum Transport des Mediums in einem gasförmigen Zustand zwischen der Einhausung und dem mindestens einen Verflüssiger angeordnet ist.

13. Verfahren zum Kühlen mindestens eines elektrischen Elements, das die folgenden Schritte umfasst:
Bereitstellen eines elektrisch isolierenden Mediums zur Isolierung des mindestens einen elektrischen Elements;
Kondensieren des Mediums aus einem gasförmigen Zustand in einen flüssigen Zustand mittels eines Verflüssigers;
Transportieren des Mediums in dem flüssigen Zustand zu mindestens einem Wärmetauschelement, das mit dem Verflüssiger fluidverbunden und zum thermischen Kontakt mit dem mindestens einen elektrischen Element zum Kühlen des mindestens einen elektrischen Elements durch das Medium ausgelegt ist,
**gekennzeichnet durch**
Bereitstellen einer Einhausung, die das mindestens eine elektrische Element umschließt, und Verdampfen des Mediums aus einem flüssigen Zustand in die Einhausung während des Kühlens des mindestens einen elektrischen Elements durch das mindestens eine Wärmetauschelement, und
Zirkulieren des Mediums von dem Verflüssiger zu dem mindestens einen Wärmetauschelement und Zirkulieren des von dem mindestens einen Wärmetauschelement verdampften Mediums zurück zu dem Verflüssiger.

14. Verfahren nach Anspruch 13, wobei es sich bei dem mindestens einen elektrischen Element um mindestens eine Wandlerzelle zur elektrischen Umwandlung handelt, wobei die mindestens eine Wandlerzelle mindestens eine Kondensatorabschirmung, mindestens ein Kondensatorelement und mindestens eine Schaltvorrichtung umfasst.

## Revendications

1. Système de refroidissement, comprenant :
au moins un élément électrique,
un milieu électriquement isolant (200) pour l'isolation de l'au moins un élément électrique,
au moins un condenseur (300) configuré pour condenser ledit milieu d'un état gazeux à un état liquide, et
au moins un élément d'échange de chaleur (600) en communication fluidique avec ledit au moins un condenseur et configuré pour un contact thermique avec l'au moins un élément électrique pour refroidir l'au moins un élément électrique par ledit milieu, ledit au moins un élément d'échange de chaleur étant configuré pour évaporer ledit milieu à partir d'un état liquide pendant le refroidissement de l'au moins un élément électrique et pour évacuer le milieu évaporé, **caractérisé en ce que** le système de refroidissement comprend en outre :
une enceinte (900) renfermant ledit au moins un élément électrique, ledit au moins un élément d'échange de chaleur étant configuré pour évacuer le milieu évaporé dans ladite enceinte, et
au moins un moyen de circulation (700) configuré pour faire circuler ledit milieu depuis ledit au moins un condenseur vers ledit au moins un élément d'échange de chaleur, et pour faire circuler ledit milieu évacué depuis ledit au moins un élément d'échange de chaleur de nouveau vers ledit au moins un condenseur.

2. Système de refroidissement selon la revendication 1, ledit au moins un élément d'échange de chaleur étant en communication fluidique en parallèle audit au moins un condenseur.

3. Système de refroidissement selon la revendication 1 ou 2, ledit au moins un élément d'échange de chaleur comprenant une pluralité de conduits pour guider ledit milieu.

4. Système de refroidissement selon l'une quelconque des revendications précédentes, comprenant en outre une unité de refroidissement couplée thermiquement audit au moins un condenseur, ladite unité de refroidissement étant configurée pour abaisser la température dudit milieu dans le condenseur au-delà du point de transition de phase gaz-liquide dudit milieu, de telle sorte que ledit milieu se condense d'un état gazeux à un état liquide.

5. Système de refroidissement selon l'une quelconque des revendications précédentes, comprenant en outre un compresseur (310) configuré pour augmenter la pression dudit milieu dans son état gazeux au-delà du point de transition de phase gaz-liquide dudit milieu, de telle sorte que ledit milieu se condense d'un état gazeux à un état liquide.

6. Système de refroidissement selon la revendication 5, ledit compresseur étant configuré pour augmenter la pression dudit milieu à 0,4-3 MPa.

7. Système de refroidissement selon l'une quelconque des revendications précédentes, au moins un conduit étant agencé comme un circuit entre ledit au moins un condenseur et ledit au moins un élément d'échange de chaleur.

8. Système de refroidissement selon l'une quelconque des revendications précédentes, ledit milieu étant au moins l'un de l'hexafluorure de soufre (SF₆) et du 1,1,1,2-Tétrafluoroéthane.

9. Système de refroidissement selon l'une quelconque des revendications précédentes, comprenant en outre :
au moins une cellule de convertisseur (500) pour une conversion électrique, ladite au moins une cellule de convertisseur comprenant au moins un blindage de condensateur (122), au moins un élément de condensateur et au moins un dispositif de commutation (127).

10. Système de refroidissement selon la revendication 9, ladite au moins une cellule de convertisseur étant agencée coaxialement pour former un empilement de cellules de convertisseur.

11. Système de refroidissement selon la revendication 9 ou 10, ledit au moins un dispositif de commutation et ledit au moins un élément d'échange de chaleur étant agencés de manière alternée en un empilement.

12. Système de refroidissement selon l'une quelconque des revendications précédentes, au moins un premier conduit (1000) étant agencé entre ledit au moins un condenseur et ledit au moins un élément d'échange de chaleur pour un transport dudit milieu à l'état liquide, et au moins un second conduit (1100) étant agencé entre ladite enceinte et ledit au moins un condenseur pour un transport dudit milieu à l'état gazeux.

13. Procédé de refroidissement d'au moins un élément électrique, comprenant les étapes de :
la fourniture d'un milieu électriquement isolant pour l'isolation de l'au moins un élément électrique ;
la condensation du milieu d'un état gazeux à un état liquide au moyen d'un condenseur ;
le transport du milieu à l'état liquide vers l'au moins un élément d'échange de chaleur en communication fluidique avec le condenseur et configuré pour un contact thermique avec l'au moins un élément électrique pour refroidir l'au moins un élément électrique par le milieu,
**caractérisé par**
la fourniture d'une enceinte renfermant ledit au moins un élément électrique et l'évaporation du milieu dans ladite enceinte à partir d'un état liquide pendant le refroidissement de l'au moins un élément électrique par l'au moins un élément d'échange de chaleur, et
le fait de faire circuler le milieu depuis le condenseur vers l'au moins un élément d'échange de chaleur et le fait de faire circuler le milieu évaporé depuis l'au moins un élément d'échange de chaleur de nouveau vers le condenseur.

14. Procédé selon la revendication 13, l'au moins un élément électrique étant au moins une cellule de convertisseur pour une conversion électrique, ladite au moins une cellule de convertisseur comprenant au moins un blindage de condensateur, au moins un élément de condensateur et au moins un dispositif de commutation.
